# EUROPEAN PATENT APPLICATION

(11) **EP 4 475 189 A1**
(43) Date of publication of application: **11.12.2024**
(21) Application number: 23749600.5
(22) Date of filing: 24.01.2023
(51) Int. Cl.: H01L 27/146, H01L 21/3205, H01L 21/768, H01L 23/522, H01L 31/0232, H01L 31/107

(54) **PHOTODETECTOR**

(30) Priority: 01.02.2022 JP 2022014277
(71) Applicant: Hamamatsu Photonics K.K., Hamamatsu-shi, Shizuoka 435-8558 (JP)
(72) Inventor: YAMADA, Ryuta, Hamamatsu-shi, Shizuoka 435-8558 (JP); OHTA, Takuji, Hamamatsu-shi, Shizuoka 435-8558 (JP)
(74) Representative: Boult Wade Tennant LLP
(86) International application number: PCT/JP2023/002122
(87) International publication number: WO 2023/149284

(57) **Abstract**

A photodetector includes a semiconductor photodetection element including a semiconductor layer having a first surface and a second surface on a side opposite to the first surface, and a light-condensing structure disposed on the first surface. The semiconductor layer includes a plurality of photodetection units which are two-dimensionally arranged along the first surface or the second surface. The light-condensing structure includes a main body portion and a metal layer. The main body portion has a plurality of first openings arranged to correspond to the plurality of photodetection units, and includes a plurality of layers stacked on the first surface. The metal layer covers an inner surface of each of the plurality of first openings to expose a region corresponding to each of the plurality of first openings in a surface of the semiconductor photodetection element. A surface of the metal layer in each of the plurality of first openings has a shape that spreads out to a side opposite to the semiconductor photodetection element.

## Description

### Technical Field

The present disclosure relates to a photodetector.

### Background Art

There is known a photodetector including a semiconductor photodetection element including a plurality of photodetection units which are two-dimensionally arranged, and a plurality of microlenses disposed on the semiconductor photodetection element to correspond to the plurality of photodetection units (for example, refer to Patent Literature 1).

### Citation List

### Patent Literature

Patent Literature 1: Japanese Unexamined Patent Publication No. 2012-256782

### Summary of Invention

### Technical Problem

In the photodetector described above, when a part of light that is a detection target is reflected from a surface of each of a plurality of microlenses, there is a concern that light-condensing efficiency for each of the plurality of photodetection units may decrease by an amount corresponding to the reflection. That is, in the photodetector described above, there is room for improvement in sensitivity.

An object of the present disclosure is to provide a photodetector capable of improving sensitivity.

### Solution to Problem

A photodetector according to an aspect of the present disclosure includes: a semiconductor photodetection element including a semiconductor layer having a first surface and a second surface on a side opposite to the first surface; and a light-condensing structure disposed on the first surface, wherein the semiconductor layer includes a plurality of photodetection units which are two-dimensionally arranged along the first surface or the second surface, the light-condensing structure includes a main body portion that has a plurality of first openings arranged to correspond to the plurality of photodetection units, and includes a plurality of layers stacked on the first surface, and a metal layer that covers an inner surface of each of the plurality of first openings to expose a region corresponding to each of the plurality of first openings in a surface of the semiconductor photodetection element, and in each of the plurality of first openings, a surface of the metal layer on a side opposite to the main body portion has a shape that spreads out to a side opposite to the semiconductor photodetection element.

In the photodetector according to the aspect of the present disclosure, when light that is a detection target is incident to the light-condensing structure, the light is reflected by a surface of the metal layer in each of the plurality of first openings provided in the main body portion. At this time, since the surface of the metal layer has a shape that spreads out to a side opposite to the semiconductor photodetection element, the light incident to the light-condensing structure is condensed to the plurality of photodetection units with high efficiency. Furthermore, since the main body portion includes a plurality of layers, it is possible to easily and reliably obtain the plurality of first openings in which the surface of the metal layer has a shape with high light-condensing efficiency. Accordingly, according to the photodetector of the aspect of the present disclosure, sensitivity can be improved.

In the photodetector according to the aspect of the present disclosure, the inner surface of each of the plurality of first openings may have a stepped shape in which each of the plurality of layers is set as at least one step. According to this, it is possible to more reliably obtain the plurality of first openings in which the surface of the metal layer has a shape with high light-condensing efficiency.

In the photodetector according to the aspect of the present disclosure, in the inner surface of each of the plurality of first openings, a width of a first face of each of the plurality of layers on an inner side may increase as being spaced apart from the semiconductor photodetection element. According to this, since the surface of the metal layer has a shape with higher light-condensing efficiency, it is possible to further raise the light-condensing efficiency for each of the plurality of photodetection units.

In the photodetector according to the aspect of the present disclosure, in the inner surface of each of the plurality of first openings, a width of a second face of each of the plurality of layers on a side opposite to the semiconductor photodetection element may decrease as being spaced apart from the semiconductor photodetection element. According to this, since the surface of the metal layer has a shape with higher light-condensing efficiency, it is possible to further raise the light-condensing efficiency for each of the plurality of photodetection units.

In the photodetector according to the aspect of the present disclosure, in the inner surface of each of the plurality of first openings, an inclination angle made between a first face of each of the plurality of layers on an inner side and the first surface may increase as being spaced apart from the semiconductor photodetection element. According to this, since the surface of the metal layer has a shape with higher light-condensing efficiency, it is possible to further raise the light-condensing efficiency for each of the plurality of photodetection units.

In the photodetector according to the aspect of the present disclosure, each of the plurality of layers may be a first layer made of a first material, or a second layer made of a second material different from the first material, and the first layer and the second layer may be alternately stacked. According to this, for example, when etching one of the first layer and the second layer from a side opposite to the semiconductor photodetection element, the other of the first layer and the second layer can serve as an etching stopper, and the plurality of first openings in which the surface of the metal layer has a shape with high light-condensing efficiency can be more easily obtained.

In the photodetector according to the aspect of the present disclosure, the first layer may be a layer in which a compressive stress occurs as an internal stress, and the second layer may be a layer in which a tensile stress occurs as an internal stress. According to this, it is possible to offset the stresses occurring in the plurality of layers in the main body portion, and it is possible to suppress the semiconductor photodetection element from being warped.

In the photodetector according to the aspect of the present disclosure, the first material may be an insulating material, and the second material may be a metal material. According to this, when etching one of the first layer and the second layer from a side opposite to the semiconductor photodetection element, the other of the first layer and the second layer can serve as an etching stopper, and it is possible to offset stresses occurring in the plurality of layers in the main body portion.

In the photodetector according to the aspect of the present disclosure, the second layer may be electrically connected to the metal layer. According to this, it is possible to suppress the semiconductor photodetection element from being adversely affected due to a situation in which the second layer made of the metal material enters an electrically floating state.

The photodetector according to the aspect of the present disclosure may further include a protective layer that covers the surface of the metal layer and the region corresponding to each of the plurality of first openings in the surface of the semiconductor photodetection element. According to this, it is possible to suppress the surface of the metal layer and a region corresponding to each of the plurality of photodetection units in the surface of the semiconductor photodetection element from deteriorating.

In the photodetector according to the aspect of the present disclosure, each of the plurality of photodetection units may include a first-conductive-type first semiconductor region and a second-conductive-type second semiconductor region, the second semiconductor region may be located on the first surface side with respect to the first semiconductor region so as to correspond to each of the plurality of first openings, and the second semiconductor region of each of the plurality of photodetection units, and a region surrounded by a skirt portion of the light-condensing structure in each of the plurality of first openings may have a polygonal shape having a plurality of chamfered corners when viewed in a direction orthogonal to the first surface. According to this, it is possible to reliably suppress an increase of noise and breakdown due to electric field concentration to each of the plurality of corners while maintaining high light-condensing efficiency for each of the plurality of photodetection units.

In the photodetector according to the aspect of the present disclosure, the second semiconductor region of each of the plurality of photodetection units, and the region surrounded by the skirt portion of the light-condensing structure in each of the plurality of first openings may have a rectangular shape having four chamfered corners as the plurality of corners when viewed in the direction orthogonal to the first surface. According to this, it is possible to reliably suppress an increase of noise and breakdown due to electric field concentration to the four corners and it is possible to accomplish simplification of a structure while maintaining high light-condensing efficiency for each of the plurality of photodetection units.

In the photodetector according to the aspect of the present disclosure, the second semiconductor region of each of the plurality of photodetection units, and the region surrounded by the skirt portion of the light-condensing structure in each of the plurality of first openings may have a hexagonal shape having six chamfered corners as the plurality of corners when viewed in the direction orthogonal to the first surface. According to this, for example, as compared with a case where the second semiconductor region of each of the plurality of photodetection units has a rectangular shape, a ratio of an insensitive region can be further decreased. In addition, for example, for example, as compared with a case where the second semiconductor region of each of the plurality of photodetection units has a rectangular shape, an interior angle of each of the six corners further increases, and thus electric field concentration to the six corners can be more reliably suppressed. In addition, for example, as compared with a case where the second semiconductor region of each of the plurality of photodetection units has a rectangular shape, the surface of the metal layer has a shape with higher light-condensing efficiency, and thus light-condensing efficiency for each of the plurality of photodetection units can be further raised. As described above, it is possible to more reliably suppress an increase of noise and breakdown due to electric field concentration to the six corners while maintaining higher light-condensing efficiency for each of the plurality of photodetection units.

In the photodetector according to the aspect of the present disclosure, each of the plurality of corners may be chamfered in a round shape. According to this, it is possible to more reliably suppress an increase of noise and breakdown due to electric field concentration to each of the plurality of corners while maintaining more high light-condensing efficiency for each of the plurality of photodetection units.

In the photodetector according to the aspect of the present disclosure, the first semiconductor region and the second semiconductor region may constitute an avalanche photodiode, the semiconductor photodetection element may further include a wiring layer formed on the first surface, the wiring layer may include a plurality of quenching resistors arranged to correspond to the plurality of photodetection units and a readout wiring having a plurality of second openings arranged to correspond to the plurality of photodetection units, one end of each of the plurality of quenching resistors may be electrically connected to the second semiconductor region of each of the plurality of photodetection units, and the other end of each of the plurality of quenching resistors may be electrically connected to the readout wiring. According to this, the semiconductor photodetection element can be caused to function as a silicon photo-multiplier (SiPM). In order to widen a dynamic range of the SiPM, it is necessary to increase the number of the photodetection units, but when increasing the number of the photodetection units while maintaining an element size, there is a concern that an occupancy ratio of an insensitive region increases and sensitivity may decrease. However, since the photodetector according to the aspect of the present disclosure includes the above-described light-condensing structure, it is possible to raise the light-condensing efficiency for each of the plurality of photodetection units even in a case of increasing the number of the photodetection units while maintaining an element size. Accordingly, in the semiconductor photodetection element functioning as the SiPM, it is possible to secure a sufficient dynamic range and sufficient sensitivity.

In the photodetector according to the aspect of the present disclosure, each of the plurality of second openings may have a polygonal shape having at least one chamfered corner when viewed in the direction orthogonal to the first surface. According to this, it is possible to suppress breakdown due to electric field concentration to the corner as compared with a case where a plurality of corners are not chamfered while maintaining higher light-condensing efficiency for each of the plurality of photodetection units.

In the photodetector according to the aspect of the present disclosure, each of the plurality of quenching resistors may overlap an outer edge of the second semiconductor region of each of the plurality of photodetection units when viewed in the direction orthogonal to the first surface, and the skirt portion of the light-condensing structure in each of the plurality of first openings may overlap a part of each of the plurality of quenching resistors when viewed in the direction orthogonal to the first surface. According to this, for example, an aperture ratio in each of the plurality of photodetection units can be raised by forming the quenching resistor with a light-transmitting material.

In the photodetector according to the aspect of the present disclosure, each of the plurality of quenching resistors may overlap an outer edge of the second semiconductor region of each of the plurality of photodetection units when viewed in the direction orthogonal to the first surface, and the skirt portion of the light-condensing structure in each of the plurality of first openings may overlap the outer edge of the second semiconductor region of each of the plurality of photodetection units and the entirety of each of the plurality of quenching resistors when viewed in the direction orthogonal to the first surface. According to this, since a step difference is formed in the metal layer due to the quenching resistor, and the surface of the metal layer has a shape with higher light-condensing efficiency, it is possible to further raise the light-condensing efficiency for each of the plurality of photodetection units. In addition, since the skirt portion of the light-condensing structure overlaps the entirety of the quenching resistor, shape stability of the light-condensing structure can be improved.

In the photodetector according to the aspect of the present disclosure, the semiconductor layer may have a trench extending to partition the plurality of photodetection units from each other, and a top portion of the light-condensing structure on a side opposite to the semiconductor photodetection element, and the trench may be included in the readout wiring when viewed in the direction orthogonal to the first surface. According to this, an effect of improving light-condensing efficiency due to the light-condensing structure, an effect of suppressing cross-talk (optical cross-talk and electrical cross-talk) due to the trench, and an effect of suppressing electric field concentration due to overhanging of the readout wiring can be obtained with balance.

In the photodetector according to the aspect of the present disclosure, the semiconductor layer may have a trench extending to partition the plurality of photodetection units from each other, and the trench may be included in the light-condensing structure when viewed in the direction orthogonal to the first surface. According to this, an effect of improving light-condensing efficiency due to the light-condensing structure and an effect of suppressing cross-talk due to the trench can be obtained with balance.

In the photodetector according to the aspect of the present disclosure, the semiconductor photodetection element may further include a wiring layer formed on the first surface, the wiring layer may include a plurality of annular electrodes arranged to correspond to the plurality of photodetection units, in each of the plurality of photodetection units, a region between the second semiconductor region and the trench may be included in each of the plurality of annular electrodes when viewed in the direction orthogonal to the first surface, and an inner edge of each of the plurality of annular electrodes may have a polygonal shape having a plurality of chamfered corners. According to this, a depletion layer formed in the region between the second semiconductor region and the trench is covered with the annular electrode, and thus it is possible to appropriately suppress electric field concentration. In addition, it is possible to suppress electric field concentration to each of the plurality of corners.

### Advantageous Effects of Invention

According to the present disclosure, it is possible to provide a photodetector capable of improving sensitivity.

### Brief Description of Drawings

[FIG. 1] FIG. 1 is a side view of a photodetector of an embodiment.
[FIG. 2] FIG. 2 is a plan view of a semiconductor photodetection element illustrated in FIG. 1.
[FIG. 3] FIG. 3 is a plan view of a part of the semiconductor photodetection element illustrated in FIG. 1.
[FIG. 4] FIG. 4 is a cross-sectional view of a part of the semiconductor photodetection element along line IV-IV shown in FIG. 3.
[FIG. 5] FIG. 5 is a circuit diagram of the semiconductor photodetection element illustrated in FIG. 1.
[FIG. 6] FIG. 6 is a cross-sectional view of a part of the photodetector illustrated in FIG. 1.
[FIG. 7] FIG. 7 is a cross-sectional view illustrating a method for manufacturing the photodetector illustrated in FIG. 1.
[FIG. 8] FIG. 8 is a cross-sectional view illustrating the method for manufacturing the photodetector illustrated in FIG. 1.
[FIG. 9] FIG. 9 is a cross-sectional view illustrating the method for manufacturing the photodetector illustrated in FIG. 1.
[FIG. 10] FIG. 10 is a cross-sectional view illustrating the method for manufacturing the photodetector illustrated in FIG. 1.
[FIG. 11] FIG. 11 is a cross-sectional view of a part of a light-condensing structure of a modification example.
[FIG. 12] FIG. 12 is a plan view of a part of a semiconductor photodetection element of the modification example.

### Description of Embodiments

Hereinafter, embodiments of the present disclosure will be described in detail with reference to the drawings. Note that, in the drawings, the same reference numerals will be given to the same or equivalent portions, and redundant description will be omitted.

### [Configuration of Photodetector]

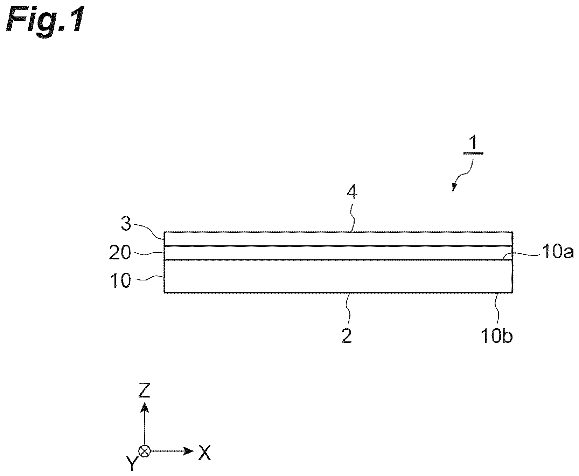

As illustrated in FIG. 1, a photodetector 1 includes a semiconductor photodetection element 2, a light-condensing structure 3, and a protective layer 4. The semiconductor photodetection element 2 includes a semiconductor layer 10 and a wiring layer 20. The semiconductor layer 10 has a first surface 10a, and a second surface 10b on a side opposite to the first surface 10a. The wiring layer 20 is formed on the first surface 10a. The light-condensing structure 3 is disposed on the first surface 10a through the wiring layer 20. In the following description, a direction orthogonal to the first surface 10a is referred to as a Z-axis direction, a direction parallel to the first surface 10a is referred to as an X-axis direction, and a direction orthogonal to the Z-axis direction and the X-axis direction is referred to as a Y-axis direction.

### [Configuration of Semiconductor Photodetection Element]

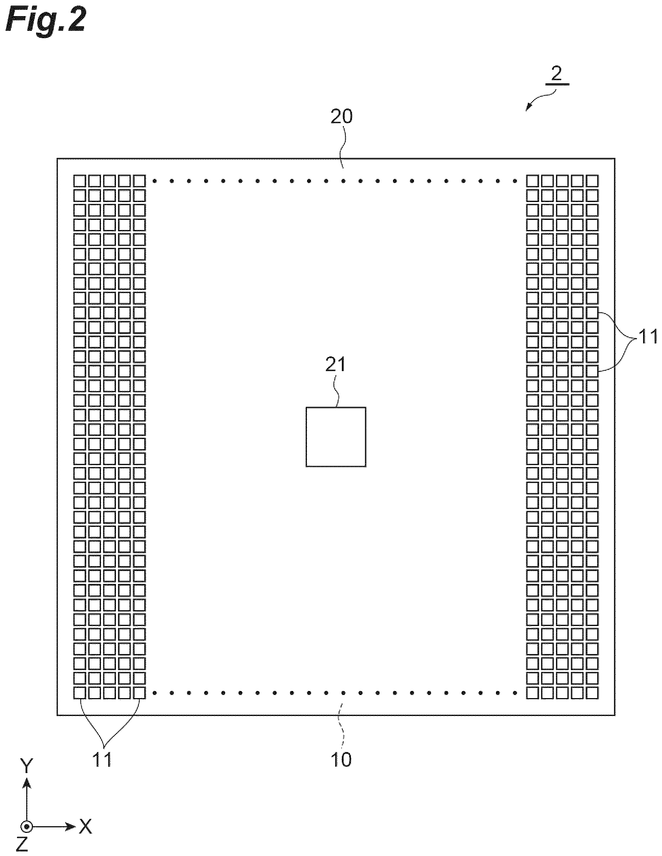

As illustrated in FIG. 2, the semiconductor layer 10 includes a plurality of photodetection units 11. The plurality of photodetection units 11 are two-dimensionally arranged along the first surface 10a (refer to FIG. 1). For example, the semiconductor layer 10 is made of silicon. The wiring layer 20 includes a common electrode 21. The common electrode 21 is located at the center of the semiconductor photodetection element 2 when viewed in the Z-axis direction. For example, the common electrode 21 is made of Al. For example, the semiconductor photodetection element 2 has a rectangular plate shape. For example, the plurality of photodetection units 11 are arranged in a matrix shape in which the X-axis direction and the Y-axis direction are set as a row direction and a column direction so as not to overlap the common electrode 21 when viewed in the Z-axis direction. In this embodiment, each of the photodetection units 11 is a single photon avalanche diode (SPAD), and the semiconductor photodetection element 2 is an SiPM. In the semiconductor photodetection element 2 that is the SiPM, a charge occurred in each of the photodetection units 11 is collected in the common electrode 21. Note that, in FIG. 2, the plurality of photodetection units 11 are illustrated at a partial region, but the plurality of photodetection units 11 are arranged in an entire region excluding the common electrode 21. In addition, in FIG. 2, the plurality of photodetection units 11, and the common electrode 21 are shown by a solid line for convenience.

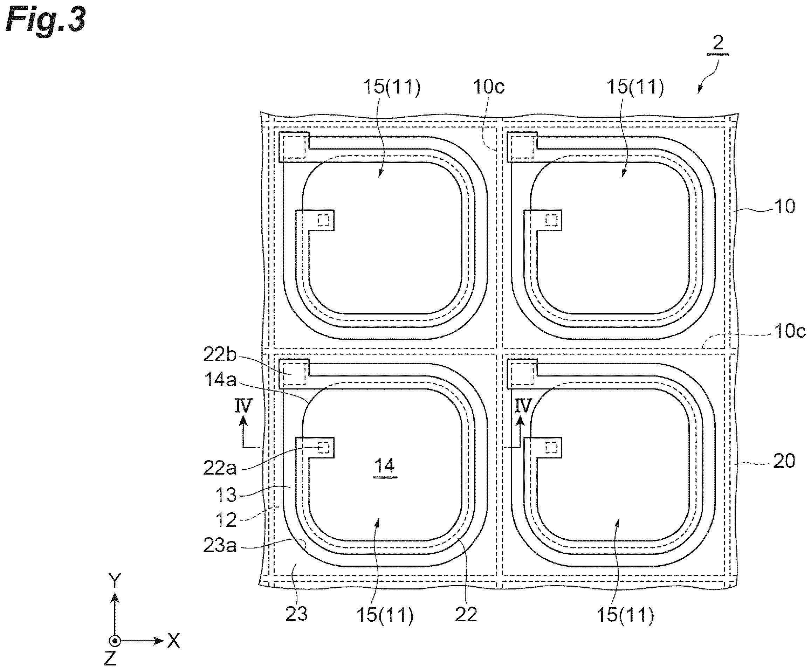

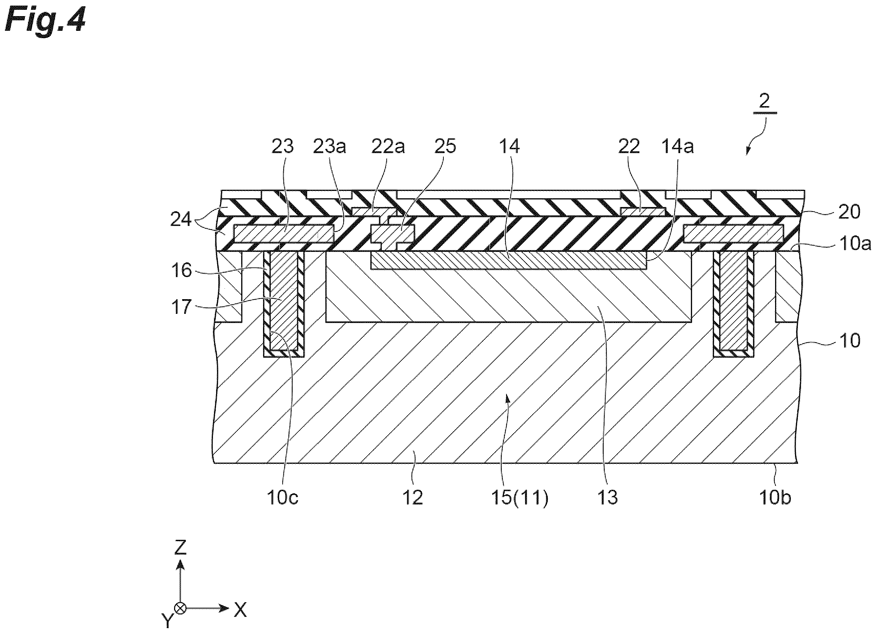

As illustrated in FIG. 3 and FIG. 4, each of the photodetection units 11 includes an N-type semiconductor region (first-conductive-type first semiconductor region) 12, a P-type semiconductor region 13, and a P⁺-type semiconductor region (second-conductive-type second semiconductor region) 14. The N-type semiconductor region 12 extends across the plurality of photodetection units 11. The P-type semiconductor region 13 is formed within the N-type semiconductor region 12 along the first surface 10a, and constitutes a PN junction with the N-type semiconductor region 12. The P⁺-type semiconductor region 14 is formed within the P-type semiconductor region 13 along the first surface 10a, and is located on the first surface 10a side with respect to at least a part of the N-type semiconductor region 12. The P⁺-type semiconductor region 14 has a rectangular shape including four chamfered corners when viewed in the Z-axis direction. The four corners are chamfered in a round shape. In each of the photodetection units 11, an avalanche photodiode 15 (hereinafter, referred to as "APD 15") is constituted by the N-type semiconductor region 12, the P-type semiconductor region 13, and the P⁺-type semiconductor region 14. As an example, a length of one side of the P⁺-type semiconductor region 14 when viewed in the Z-axis direction is approximately 10 µm, and a center-to-center distance (pitch) between adjacent P⁺-type semiconductor regions 14 is approximately 15 µm. In the semiconductor layer 10, a P-type impurity is, for example, an element of group 3 such as B, and an N-type impurity is, for example, an element of group 5 such as N, P, and As.

The semiconductor layer 10 includes a trench 10c. The trench 10c extends in such a manner of partitioning the photodetection units 11 from each other. The trench 10c is opened through the first surface 10a. A depth of the trench 10c from the first surface 10a is larger than a depth of the P-type semiconductor region 13 from the first surface 10a. In each of the photodetection units 11, a part of the N-type semiconductor region 12 is disposed between the P-type semiconductor region 13 and the trench 10c. An insulating region 16 is formed along an inner surface of the trench 10c. For example, the insulating region 16 is made of SiO₂. A metal member 17 is disposed in the trench 10c. For example, the metal member 17 is made of W. As an example, a width of the trench 10c is approximately 0.5 µm, and the depth of the trench 10c is approximately 4 µm. As an example, a distance between the P-type semiconductor region 13 and the trench 10c (that is, a width of a part of the N-type semiconductor region 12 disposed between the P-type semiconductor region 13 and the trench 10c) is approximately 2 µm. Note that, the depth of the trench 10c from the first surface 10a may reach the second surface 10b.

The wiring layer 20 includes a plurality of quenching resistors 22, a readout wiring 23, and an insulating layer 24 in addition to the common electrode 21 (refer to FIG. 2). For example, the insulating layer 24 is constituted by a plurality of insulating films made of SiO₂ or SiN. The plurality of quenching resistors 22 and the readout wiring 23 are formed in the insulating layer 24. The plurality of quenching resistors 22 are arranged to correspond to the plurality of photodetection units 11. One of the quenching resistors 22 corresponds to one of the photodetection units 11. For example, the quenching resistors 22 is made of SiCr. The readout wiring 23 includes a plurality of openings (second openings) 23a. The plurality of openings 23a are arranged to correspond to the plurality of photodetection units 11. One of the openings 23a corresponds to one of the photodetection units 11. In other words, one piece of the P⁺-type semiconductor region 14 overlaps one of the openings 23a when viewed in the Z-axis direction. The readout wiring 23 extends across the plurality of photodetection units 11, and is electrically connected to the common electrode 21. For example, the readout wiring 23 is made of Al. The trench 10c is included in the readout wiring 23 when viewed in the Z-axis direction. Note that, in FIG. 3, illustration of the insulating layer 24 is omitted.

In each of the photodetection units 11, the P⁺-type semiconductor region 14 and each of the quenching resistors 22 are disposed on an inner side of each of the openings 23a when viewed in the Z-axis direction. The opening 23a has a rectangular shape including three chamfered corners when viewed in the Z-axis direction. The three corners are chamfered in a round shape. In each of the photodetection units 11, the quenching resistor 22 overlaps an outer edge 14a of the P⁺-type semiconductor region 14 when viewed in the Z-axis direction, and extends along the outer edge 14a of the P⁺-type semiconductor region 14 when viewed in the Z-axis direction. One end 22a of the quenching resistor 22 is electrically connected to the P⁺-type semiconductor region 14 through a through-electrode 25 in the vicinity of a part of the outer edge 14a. For example, the through-electrode 25 is made of Al. The other end 22b of the quenching resistor 22 is electrically connected to a readout wiring 23 in each corner that is not chamfered in the opening 23a.

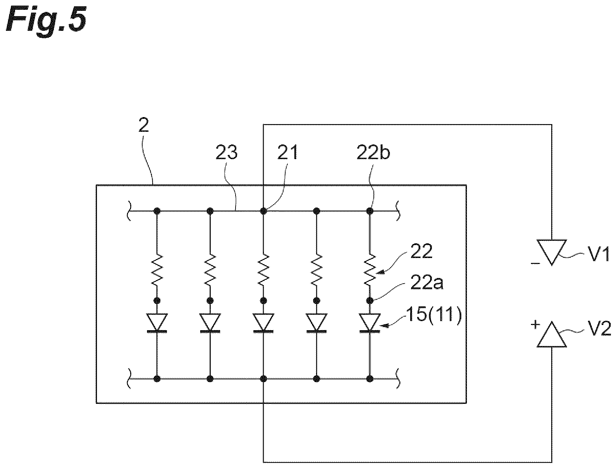

FIG. 5 is a circuit diagram of the semiconductor photodetection element 2. As illustrated in FIG. 5, the one end 22a of each of the quenching resistors 22 is electrically connected to an anode of each APD 15. The other end 22b of each of the quenching resistors 22 is electrically connected to the common electrode 21 through the readout wiring 23. In the semiconductor photodetection element 2, the APD 15 is operated in a Geiger mode. In the Geiger mode, a reverse voltage (reverse bias voltage) larger than a breakdown voltage of the APD 15 is applied to the APD 15. That is, in a case where a potential V1 is applied to an anode of the APD 15, a voltage V2, which is a positive potential with respect to the potential V1 and whose difference with the potential V1 is larger than the breakdown voltage of the APD 15, is applied to a cathode of the APD 15. In a state in which the APD 15 can be operated in the Geiger mode, when light is incident to at least any one APD 15, photoelectric conversion occurs in the APD 15, and charges are generated in the APD 15. The charges generated in the APD 15 are amplified by avalanche multiplication, and are collected in the common electrode 21 through the quenching resistor 22. The charges collected in the common electrode 21 are output as a signal to an outer signal processing unit.

### [Configuration of Light-Condensing Structure and Protective Layer]

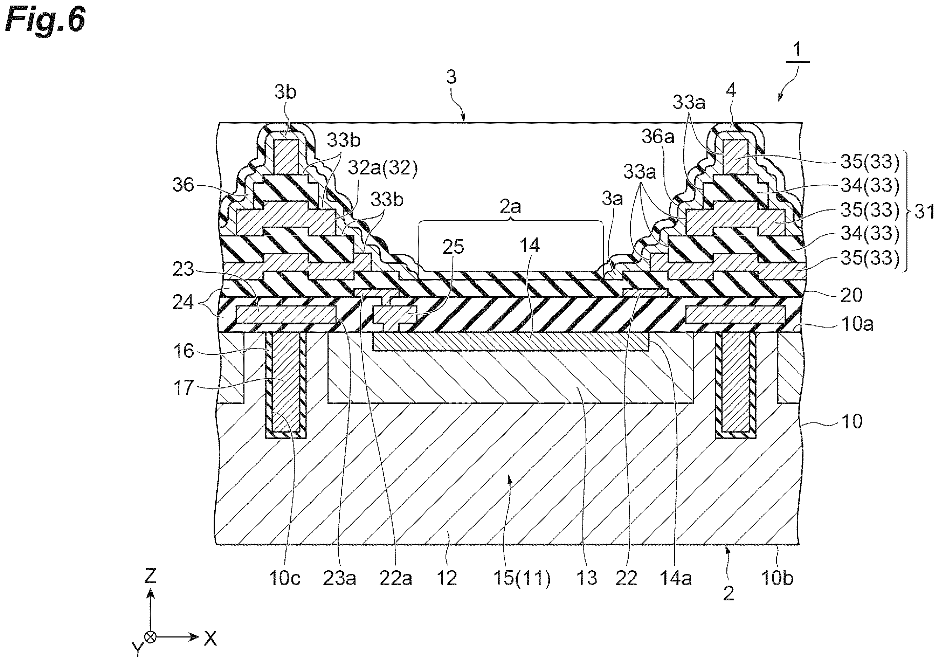

As illustrated in FIG. 6, the light-condensing structure 3 includes a main body portion 31. The main body portion 31 includes a plurality of openings (first openings) 32. The plurality of openings 32 are arranged to correspond to the plurality of photodetection units 11. One of the openings 32 corresponds to one of the photodetection units 11. In other words, one piece of the P⁺-type semiconductor region 14 overlaps one of the openings 32 when viewed in the Z-axis direction. The main body portion 31 is disposed on the first surface 10a through the wiring layer 20, and extends across the plurality of photodetection units 11.

The main body portion 31 includes a plurality of layers 33. The plurality of layers 33 are stacked on the first surface 10a through the wiring layer 20. Each of the layers 33 is a first layer 34 or a second layer 35. In the main body portion 31, the first layer 34 and the second layer 35 are alternately stacked. The first layer 34 is a layer made of an insulating material (first material) and is a layer in which a compressive stress occurs as an internal stress. For example, the first layer 34 is made of SiO₂. The second layer 35 is a layer made of a metal material (a second material different from the first material), and is a layer in which a tensile stress occurs as an internal stress. For example, the second layer 35 is made of Al.

An inner surface 32a of each of the openings 32 has a stepped shape in which each of the layers 33 is set as at least one step. That is, the inner surface 32a of each of the openings 32 is constituted by a plurality of first faces 33a corresponding to a rise surface, and a plurality of second faces 33b corresponding to a ground surface. In the inner surface 32a of each of the openings 32, each of the first faces 33a is an inner surface (that is, surface facing a central line side of the opening 32) in each of the layers 33, and extends in a frame shape (for example, a rectangular shape) to surround the central line of the opening 32. A width of each of the first faces 33a is, for example, approximately 0.5 µm. An inclination angle made between the first face 33a and the first surface 10a is, for example, 90°. In the inner surface 32a of each of the openings 32, each of the second faces 33b is a surface of each of the layers 33 on a side opposite to the semiconductor photodetection element 2, and extends in a frame shape (for example, a rectangular shape) to surround the central line of the opening 32. A width of each of the second faces 33b is, for example, approximately 0.5 µm. Note that, the width of the first face 33a is "a width of the first face 33a in a direction orthogonal to the first surface 10a" on a cross-section including the central line of the opening 32. An inclination angle made between the first face 33a and the first surface 10a is "an angle between the first surface 10a and the first face 33a on the layer 33 side" on the cross-section including the central line of the opening 32. A width of the second face 33b is "a width of the second face 33b in a direction parallel to the first surface 10a" on a cross-section including the central line of the opening 32.

The light-condensing structure 3 further includes a metal layer 36. The metal layer 36 covers the main body portion 31 in a state of exposing a region 2a corresponding to each of the openings 32 in a surface of the semiconductor photodetection element 2. That is, the metal layer 36 covers the inner surface 32a of each of the openings 32 in a manner of exposing the region 2a corresponding to each of the openings 32 in the surface of the semiconductor photodetection element 2. The region 2a is a region that overlaps (or is included in) the P⁺-type semiconductor region 14 of each of the photodetection units 11 when viewed in the Z-axis direction in the surface of the semiconductor photodetection element 2 (in this embodiment, a surface of the wiring layer 20 on a side opposite to the semiconductor layer 10). The metal layer 36 is made of, for example, Al.

In each of the openings 32, a surface 36a of the metal layer 36 on a side opposite to the main body portion 31 has a shape that spreads out toward a side opposite to the semiconductor photodetection element 2. Here, the shape that spreads out to a side opposite to the semiconductor photodetection element 2 includes not only a shape that continuously spreads out to a side opposite to the semiconductor photodetection element 2 but also a shape that spreads out step by step to a side opposite to the semiconductor photodetection element 2 (that is, a shape including a section in which an area of a cross-section orthogonal to the central line of the opening 32 is constant). The second layer 35 made of a metal material is electrically connected to the metal layer 36. Note that, the metal layer 36 is electrically connected to a reference potential point (for example, a ground potential point).

A region surrounded by a skirt portion 3a of the light-condensing structure 3 in the opening 32 has a rectangular shape having four chamfered corners when viewed in the Z-axis direction. The four corners are chamfered in a round shape. The skirt portion 3a of the light-condensing structure 3 in the opening 32 is a frame-shaped portion that defines each region 2a in the light-condensing structure 3. The skirt portion 3a of the light-condensing structure 3 in the opening 32 overlaps the outer edge 14a of the P⁺-type semiconductor region 14 of each of the photodetection units 11 and the entirety of each of the quenching resistors 22 when viewed in the Z-axis direction. A top portion 3b of the light-condensing structure 3 on a side opposite to the semiconductor photodetection element 2 extends in such a manner of partitioning the photodetection units 11 from each other when viewed in the Z-axis direction. The top portion 3b of the light-condensing structure 3 is included in the readout wiring 23 when viewed in the Z-axis direction. As an example, a height of the light-condensing structure 3 from the region 2a is approximately 3 µm, and a distance between a plurality of the regions 2a adjacent to each other is approximately 5 µm.

The protective layer 4 covers the surface 36a of the metal layer 36 and the plurality of regions 2a. The protective layer 4 extends across the plurality of photodetection units 11. For example, the protective layer 4 is made of SiO₂.

### [Method for Manufacturing Photodetector]

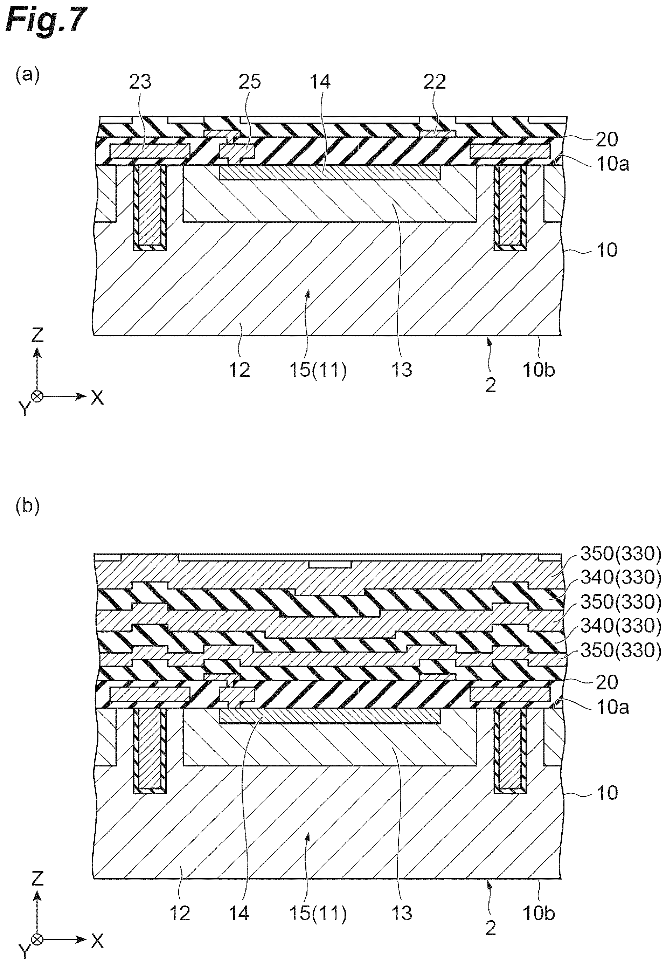

As illustrated in (a) of FIG. 7, the semiconductor photodetection element 2 is prepared. Next, as illustrated in (b) of FIG. 7, a plurality of layers 330 are stacked on the first surface 10a through the wiring layer 20. Each of the layers 330 is an insulating layer 340 or a metal layer 350. Here, the insulating layer 340 and the metal layer 350 are alternately stacked.

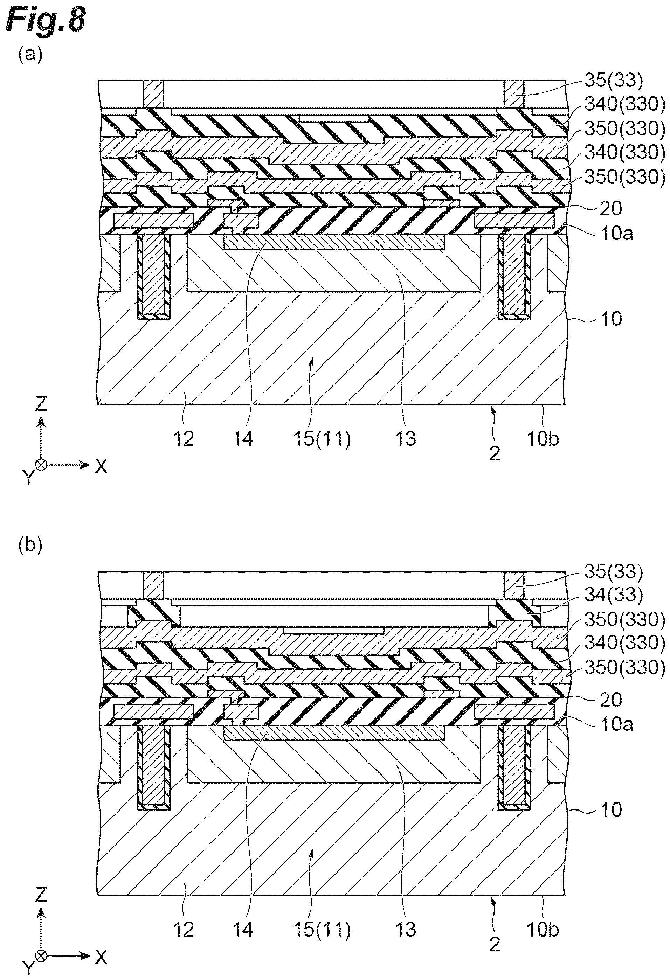

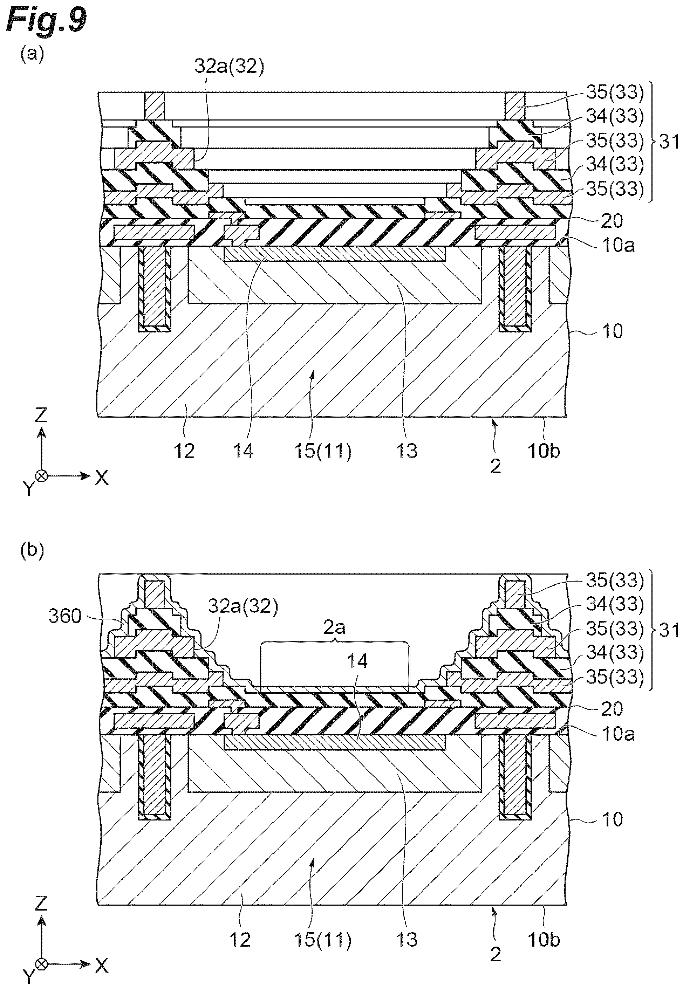

Next, as illustrated in (a) and (b) of FIG. 8, and (a) of FIG. 9, each of the layers 330 is patterned by etching in the order from a side away from the semiconductor photodetection element 2 to form the main body portion 31 having the plurality of the openings 32. At this time, the insulating layer 340 becomes the first layer 34 and the metal layer 350 becomes the second layer 35. In the etching of each of the layers 330, a layer 330 that is in contact with a layer 330 to be etched from the semiconductor photodetection element 2 side functions as an etching stopper. That is, in a case where the layer 330 to be etched is the insulating layer 340, the metal layer 350 that is in contact with the insulating layer 340 from the semiconductor photodetection element 2 side functions as the etching stopper, and in a case where the layer 330 to be etched is the metal layer 350, the insulating layer 340 that is in contact with the metal layer 350 from the semiconductor photodetection element 2 side functions as the etching stopper.

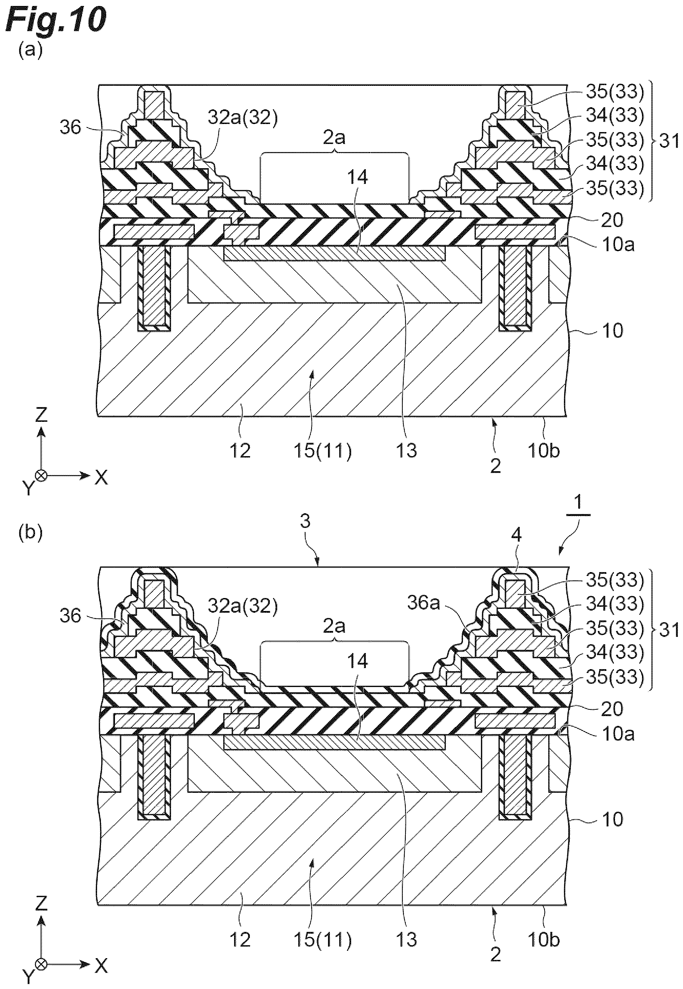

Next, as illustrated in (b) of FIG. 9, a metal layer 360 is formed to cover the region 2a corresponding to each of the openings 32 in the surface of the semiconductor photodetection element 2 and the main body portion 31. Next, as illustrated in (a) of FIG. 10, a portion of the metal layer 360 on the region 2a is removed by etching to form the metal layer 36. Next, as illustrated in (b) of FIG. 10, the protective layer 4 is formed to cover the surface 36a of the metal layer 36, and a plurality of the regions 2a. In this manner, the photodetector 1 is manufactured.

### [Operation and Effect]

In the photodetector 1, when light that is a detection target is incident to the light-condensing structure 3, in each of the openings 32 provided in the main body portion 31, the light is reflected by the surface 36a of the metal layer 36. At this time, since the surface 36a of the metal layer 36 has a shape that spreads out to a side opposite to the semiconductor photodetection element 2, the light incident to the light-condensing structure 3 is condensed to each of the photodetection units 11 with high efficiency. Furthermore, since the main body portion 31 includes the plurality of layers 33, the plurality of openings 32 in which the surface 36a of the metal layer 36 has a shape with high light-condensing efficiency can be easily and reliably obtained. Accordingly, according to the photodetector 1, sensitivity can be improved.

In the photodetector 1, the inner surface 32a of each of the openings 32 has a stepped shape in which each of the layers 33 is set as at least one step. According to this, the plurality of openings 32 in which the surface 36a of the metal layer 36 has a shape with high light-condensing efficiency can be more reliably obtained. Note that, as the thickness of each of the layers 33 decreases, minute adjustment in the shape of the opening 32 can be realized, and the inner surface 32a of the opening 32 is covered with the metal layer 36, and thus a smooth surface 36a can be formed in the opening 32.

In the photodetector 1, each of the layers 33 is the first layer 34 made of the first material or the second layer 35 made of the second material different from the first material, and the first layer 34 and the second layer 35 are alternately stacked. According to this, for example, when etching one of the first layer 34 and the second layer 35 from a side opposite to the semiconductor photodetection element 2, the other of the first layer 34 and the second layer 35 can serve as an etching stopper, and the plurality of openings 32 in which the surface 36a of the metal layer 36 has a shape with high light-condensing efficiency can be more easily obtained.

In the photodetector 1, the first layer 34 is a layer in which a compressive stress occurs as an internal stress, and the second layer 35 is a layer in which a tensile stress occurs as an internal stress. According to this, it is possible to offset the stresses occurring in the plurality of layers 33 in the main body portion 31, and it is possible to suppress the semiconductor photodetection element 2 from being warped.

In the photodetector 1, the first layer 34 is made of an insulating material, and the second layer 35 is made of a metal material. According to this, when etching one of the first layer 34 and the second layer 35 from a side opposite to the semiconductor photodetection element 2, the other of the first layer 34 and the second layer 35 can serve as an etching stopper, and it is possible to offset the stresses occurring in the plurality of layers 33 in the main body portion 31.

In the photodetector 1, the second layer 35 made of a metal material is electrically connected to the metal layer 36. According to this, it is possible to suppress the semiconductor photodetection element 2 from being adversely affected due to a situation in which the second layer 35 made of the metal material enters an electrically floating state.

In the photodetector 1, the protective layer 4 covers the surface 36a of the metal layer 36 and the plurality of regions 2a. According to this, it is possible to suppress the surface 36a of the metal layer 36, and the plurality of regions 2a from deteriorating.

In the photodetector 1, the P⁺-type semiconductor region 14 of each of the photodetection units 11, and the region surrounded by the skirt portion 3a of the light-condensing structure 3 in each of the openings 32 have a rectangular shape having four chamfered corners when viewed in the Z-axis direction. According to this, it is possible to reliably suppress an increase of noise and breakdown due to electric field concentration to the four corners while maintaining high light-condensing efficiency for the photodetection unit 11, and it is possible to accomplish simplification of a structure.

In the photodetector 1, the four corners are chamfered in a round shape. According to this, it is possible to more reliably suppress the increase of noise and the breakdown due to electric field concentration to the four corners while maintaining more high light-condensing efficiency for the photodetection unit 11.

In the photodetector 1, the semiconductor photodetection element 2 functions as an SiPM. In order to widen a dynamic range of the SiPM, it is necessary to increase the number of the photodetection units 11, but when increasing the number of the photodetection units 11 while maintaining an element size, there is a concern that an occupancy ratio of an insensitive region increases and sensitivity may decrease. However, since the photodetector 1 includes the above-described light-condensing structure 3, it is possible to raise the light-condensing efficiency for each of the photodetection units 11 even in a case of increasing the number of the photodetection units 11 while maintaining an element size. Accordingly, in the semiconductor photodetection element 2 functioning as the SiPM, it is possible to secure a sufficient dynamic range and sufficient sensitivity.

In the photodetector 1, each of the openings 23a of the readout wiring 23 has a rectangular shape having at least one chamfered corner when viewed in the Z-axis direction. According to this, it is possible to further suppress breakdown due to electric field concentration in each corner as compared with a case where four corners are not chamfered while maintaining high light-condensing efficiency for each of the photodetection units 11.

In the photodetector 1, each of the quenching resistors 22 overlaps the outer edge 14a of the P⁺-type semiconductor region 14 of each of the photodetection units 11 when viewed in the Z-axis direction, and the skirt portion 3a of the light-condensing structure 3 in each of the openings 32 overlaps the outer edge 14a of the P⁺-type semiconductor region 14 of each of the photodetection unit 11 and the entirety of each the quenching resistor 22 when viewed in the Z-axis direction. According to this, since a step difference is formed in the metal layer 36 due to the quenching resistor 22, and the surface 36a of the metal layer 36 has a shape with higher light-condensing efficiency, it is possible to further raise the light-condensing efficiency for the photodetection unit 11. In addition, since the skirt portion 3a of the light-condensing structure 3 overlaps the entirety of the quenching resistor 22, shape stability of the light-condensing structure 3 can be improved.

In the photodetector 1, the semiconductor layer 10 includes the trench 10c that extends in such a manner of partitioning the photodetection units 11 from each other, and the top portion 3b of the light-condensing structure 3 and the trench 10c are included in the readout wiring 23 when viewed in the Z-axis direction. According to this, an effect of improving light-condensing efficiency due to the light-condensing structure 3, an effect of suppressing cross-talk (optical cross-talk and electrical cross-talk) due to the trench 10c, and an effect of suppressing electric field concentration due to overhanging of the readout wiring 23 can be obtained with balance. In addition, since a depletion layer formed in a region between the P⁺-type semiconductor region 14 and the trench 10c is covered with the readout wiring 23, electric field concentration can be appropriately suppressed, and since a PN junction interface formed between a region between the P⁺-type semiconductor region 14 and the trench 10c is covered with the readout wiring 23, the electric field concentration can be more appropriately suppressed.

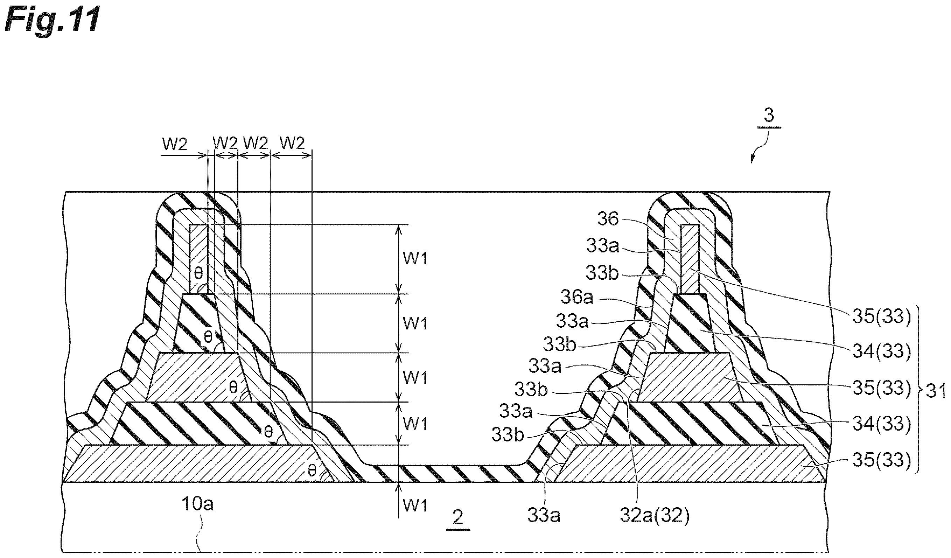

Here, description will be given of a configuration of the light-condensing structure 3 capable of further raising the light-condensing efficiency for each of the photodetection units 11. In order to further raise the light-condensing efficiency for each of the photodetection units 11, the shape of the surface 36a of the metal layer 36 in each of the openings 32 may be made closer to a compound-parabolic-concentrator (CPC) shape. A configuration of the light-condensing structure 3 for realizing this is as follows. Specifically, as illustrated in FIG. 11, in the inner surface 32a of the opening 32, when a width W1 of the first face 33a of each of the layers 33 increases as being spaced apart from the semiconductor photodetection element 2, the shape of the surface 36a of the metal layer 36 is closer to the CPC shape. In addition, in the inner surface 32a of the opening 32, as a width W2 of the second face 33b of the layer 33 decreases as being spaced apart from the semiconductor photodetection element 2, the shape of the surface 36a of the metal layer 36 is closer to the CPC shape. In addition, in the inner surface 32a of the opening 32, as an inclination angle θ made between the first face 33a of the layer 33 and the first surface 10a increases as being spaced apart from the semiconductor photodetection element 2, the shape of the surface 36a of the metal layer 36 is closer to the CPC shape. When at least one configuration among the above-described configurations is applied to the light-condensing structure 3, the surface 36a of the metal layer 36 becomes a shape with higher light-condensing efficiency, and thus the light-condensing efficiency for the photodetection unit 11 can be further raised.

### [Modification Example]

The present disclosure is not limited to the above-described embodiment. For example, in the semiconductor photodetection element 2 functioning as the SiPM, each of the photodetection units 11 may have another configuration such as a configuration in which an N-type and a P-type are reversed. As an example, the N-type semiconductor region (first-conductive-type first semiconductor region) 12, the P-type semiconductor region 13, and the P⁺-type semiconductor region (second-conductive-type second semiconductor region) 14 may be a P-type semiconductor region (first-conductive-type first semiconductor region), an N⁻-type semiconductor region, and an N-type semiconductor region (second-conductive-type second semiconductor region). In addition, each of the photodetection units 11 is not limited to a configuration constituting the avalanche photodiode as long as the photodetection unit 11 constitutes a photodiode constituted by a P-type semiconductor region and an N-type semiconductor region. In addition, the semiconductor photodetection element 2 may be a rear surface incident type. That is, the semiconductor layer 10 may include a plurality of photodetection units 11 which are two-dimensionally arranged along the second surface 10b. In this case, a trench 10c that is opened through the second surface 10b and extends in such a manner of partitioning the photodetection units 11 from each other may be formed in the semiconductor layer 10.

In the semiconductor photodetection element 2, the wiring layer 20 may not be formed on the first surface 10a. In this case, the light-condensing structure 3 may be disposed directly on the first surface 10a. That is, the plurality of layers 33 of the main body portion 31 may be stacked directly on the first surface 10a.

In the photodetector 1, the P⁺-type semiconductor region 14 of each of the photodetection units 11, and the region surrounded by the skirt portion 3a of the light-condensing structure 3 in each of the openings 32 may have a shape (for example, a polygonal shape other than the rectangular shape, a circular shape, or the like) other than "the rectangular shape having four chamfered corners" when viewed in the Z-axis direction. When the P⁺-type semiconductor region 14 of the photodetection unit 11 and the region surrounded by the skirt portion 3a of the light-condensing structure 3 in each of the openings 32 have the polygonal shape having a plurality of chamfered corners when viewed in the Z-axis direction, it is possible to reliably suppress an increase of noise and breakdown due to electric field concentration to each of the plurality of corners while maintaining high light-condensing efficiency for the photodetection unit 11. In this case, each of the openings 23a of the readout wiring 23 has a polygonal shape having at least one chamfered corner when viewed in the Z-axis direction, it is possible to more reliably suppress breakdown due to electric field concentration to the corner as compared with a case where a plurality of corners are not chamfered while maintaining higher light-condensing efficiency for each of the photodetection units 11.

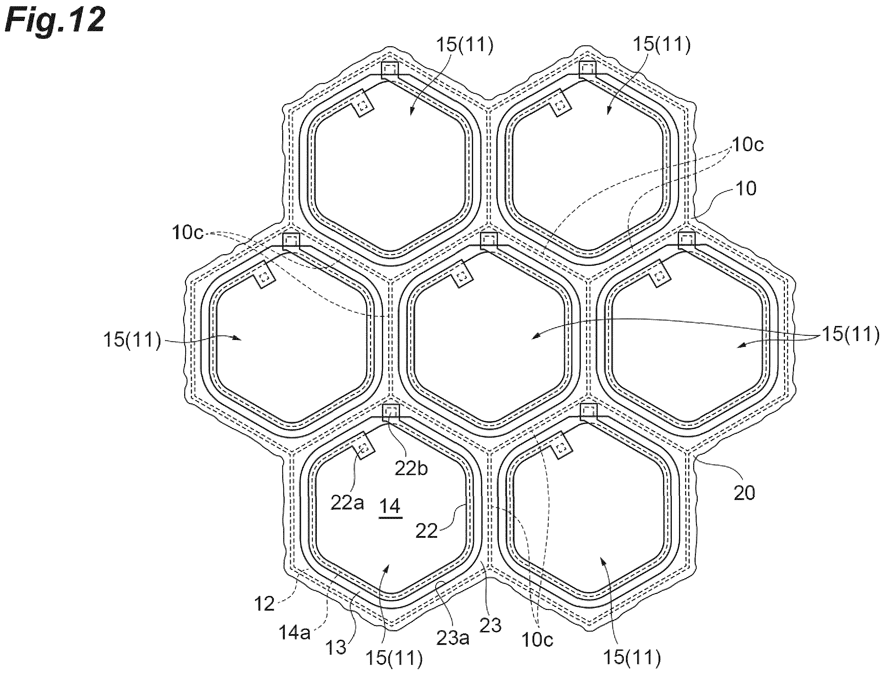

As an example, as illustrated in FIG. 12, the P⁺-type semiconductor region 14 of each of the photodetection units 11 and the region surrounded by the skirt portion 3a (not illustrated) of the light-condensing structure 3 in each of the openings 32 may have a hexagonal shape having six chamfered corners when viewed in the Z-axis direction. According to this, for example, as compared with a case where the P⁺-type semiconductor region 14 of each of the photodetection units 11 has a rectangular shape, a ratio of an insensitive region can be further decreased. In addition, for example, as compared with a case where the P⁺-type semiconductor region 14 of each of the photodetection units 11 has a rectangular shape, an interior angle of each of the six corners further increases, and thus electric field concentration to the six corners can be more reliably suppressed. In addition, for example, as compared with a case where the P⁺-type semiconductor region 14 of each of the photodetection units 11 has a rectangular shape, the surface 36a of the metal layer 36 has a shape with higher light-condensing efficiency, and thus light-condensing efficiency for the photodetection unit 11 can be further raised. As described above, it is possible to more reliably suppress an increase of noise and breakdown due to electric field concentration to the six corners while maintaining higher light-condensing efficiency for the photodetection unit 11. In the example illustrated in FIG. 12, when the six corners are chamfered in a round shape, it is possible to more reliably suppress an increase of noise and breakdown due to electric field concentration to the six corners while maintaining higher light-condensing efficiency for the photodetection unit 11.

In the light-condensing structure 3, each of the openings 23a may have a rectangular shape having at least one chamfered corner when viewed in the Z-axis direction. In this case, the chamfered shape is also not limited to the round shape. In addition, in the light-condensing structure 3, the first layer 34 and the second layer 35 may be layers made of materials different from each other. In addition, in the light-condensing structure 3, the respective layers 33 may be layers made of the same material. In addition, the inner surface 32a of each of the openings 32 may have a stepped shape in which a plurality of continuous layers 33 are set as one step.

The skirt portion 3a of the light-condensing structure 3 in each of the openings 32 may overlap a part of each of the quenching resistors 22 when viewed in the Z-axis direction. According to this, for example, an aperture ratio in each of the photodetection units 11 can be raised by forming the quenching resistor 22 with a light-transmitting material (for example, polysilicon).

In the photodetector 1, when the trench 10c is included in the light-condensing structure 3 when viewed in the Z-axis direction, an effect of improving light-condensing efficiency due to the light-condensing structure 3 and an effect of suppressing cross-talk due to the trench 10c can be obtained with balance. In this case, the wiring layer 20 may include a plurality of annular electrodes arranged to correspond to the plurality of photodetection units 11, in each of the photodetection units 11, a region between the second-conductive-type second semiconductor region (for example, the P⁺-type semiconductor region 14) and the trench 10c may be included in each of the annular electrodes when viewed in the Z-axis direction, and an inner edge of the annular electrode may have a polygonal shape having a plurality of chamfered corners. According to this, a depletion layer formed in the region between the second semiconductor region and the trench 10c is covered with the annular electrode, and thus it is possible to appropriately suppress electric field concentration. In addition, a PN junction interface formed in the region between the second semiconductor region and the trench 10c is covered with the annular electrode, and thus it is possible to more appropriately suppress the electric field concentration. In addition, it is also possible to suppress electric field concentration to each of the plurality of corners.

### Reference Signs List

1: photodetector, 2: semiconductor photodetection element, 2a: region, 3: light-condensing structure, 3a: skirt portion, 3b: top portion, 4: protective layer, 10: semiconductor layer, 10a: first surface, 10b: second surface, 10c: trench, 11: photodetection unit, 12: N-type semiconductor region (first-conductive-type first semiconductor region), 14: P⁺-type semiconductor region (second-conductive-type second semiconductor region), 14a: outer edge, 15: APD, 20: wiring layer, 22: quenching resistor, 22a: one end, 22b: other end, 23: readout wiring, 23a: opening (second opening), 31: main body portion, 32: opening (first opening), 32a: inner surface, 33: layer, 33a: first face, 33b: second face, 34: first layer, 35: second layer, 36: metal layer, 36a: surface.

## Claims

1. A photodetector, comprising:
a semiconductor photodetection element including a semiconductor layer having a first surface and a second surface on a side opposite to the first surface; and
a light-condensing structure disposed on the first surface,
wherein the semiconductor layer includes a plurality of photodetection units which are two-dimensionally arranged along the first surface or the second surface,
the light-condensing structure includes,
a main body portion that has a plurality of first openings arranged to correspond to the plurality of photodetection units, and includes a plurality of layers stacked on the first surface, and
a metal layer that covers an inner surface of each of the plurality of first openings to expose a region corresponding to each of the plurality of first openings in a surface of the semiconductor photodetection element, and
in each of the plurality of first openings, a surface of the metal layer on a side opposite to the main body portion has a shape that spreads out to a side opposite to the semiconductor photodetection element.

2. The photodetector according to claim 1,
wherein the inner surface of each of the plurality of first openings has a stepped shape in which each of the plurality of layers is set as at least one step.

3. The photodetector according to claim 2,
wherein in the inner surface of each of the plurality of first openings, a width of a first face of each of the plurality of layers on an inner side increases as being spaced apart from the semiconductor photodetection element.

4. The photodetector according to claim 2 or 3,
wherein in the inner surface of each of the plurality of first openings, a width of a second face of each of the plurality of layers on a side opposite to the semiconductor photodetection element decreases as being spaced apart from the semiconductor photodetection element.

5. The photodetector according to any one of claims 2 to 4,
wherein in the inner surface of each of the plurality of first openings, an inclination angle made between a first face of each of the plurality of layers on an inner side and the first surface increases as being spaced apart from the semiconductor photodetection element.

6. The photodetector according to any one of claims 1 to 5,
wherein each of the plurality of layers is a first layer made of a first material, or a second layer made of a second material different from the first material, and
the first layer and the second layer are alternately stacked.

7. The photodetector according to claim 6,
wherein the first layer is a layer in which a compressive stress occurs as an internal stress, and
the second layer is a layer in which a tensile stress occurs as an internal stress.

8. The photodetector according to claim 6 or 7,
wherein the first material is an insulating material, and
the second material is a metal material.

9. The photodetector according to claim 8,
wherein the second layer is electrically connected to the metal layer.

10. The photodetector according to any one of claims 1 to 9, further comprising:
a protective layer that covers the surface of the metal layer and the region corresponding to each of the plurality of first openings in the surface of the semiconductor photodetection element.

11. The photodetector according to any one of claims 1 to 10,
wherein each of the plurality of photodetection units includes a first-conductive-type first semiconductor region and a second-conductive-type second semiconductor region,
the second semiconductor region is located on the first surface side with respect to the first semiconductor region so as to correspond to each of the plurality of first openings, and
the second semiconductor region of each of the plurality of photodetection units, and a region surrounded by a skirt portion of the light-condensing structure in each of the plurality of first openings have a polygonal shape having a plurality of chamfered corners when viewed in a direction orthogonal to the first surface.

12. The photodetector according to claim 11,
wherein the second semiconductor region of each of the plurality of photodetection units, and the region surrounded by the skirt portion of the light-condensing structure in each of the plurality of first openings have a rectangular shape having four chamfered corners as the plurality of corners when viewed in the direction orthogonal to the first surface.

13. The photodetector according to claim 11,
wherein the second semiconductor region of each of the plurality of photodetection units, and the region surrounded by the skirt portion of the light-condensing structure in each of the plurality of first openings have a hexagonal shape having six chamfered corners as the plurality of corners when viewed in the direction orthogonal to the first surface.

14. The photodetector according to any one of claims 11 to 13,
wherein each of the plurality of corners is chamfered in a round shape.

15. The photodetector according to any one of claims 11 to 14,
wherein the first semiconductor region and the second semiconductor region constitute an avalanche photodiode,
the semiconductor photodetection element further includes a wiring layer formed on the first surface,
the wiring layer includes,
a plurality of quenching resistors arranged to correspond to the plurality of photodetection units, and
a readout wiring having a plurality of second openings arranged to correspond to the plurality of photodetection units,
one end of each of the plurality of quenching resistors is electrically connected to the second semiconductor region of each of the plurality of photodetection units, and
the other end of each of the plurality of quenching resistors is electrically connected to the readout wiring.

16. The photodetector according to claim 15,
wherein each of the plurality of second openings has a polygonal shape having at least one chamfered corner when viewed in the direction orthogonal to the first surface.

17. The photodetector according to claim 15 or 16,
wherein each of the plurality of quenching resistors overlaps an outer edge of the second semiconductor region of each of the plurality of photodetection units when viewed in the direction orthogonal to the first surface, and
the skirt portion of the light-condensing structure in each of the plurality of first openings overlaps a part of each of the plurality of quenching resistors when viewed in the direction orthogonal to the first surface.

18. The photodetector according to claim 15 or 16,
wherein each of the plurality of quenching resistors overlaps an outer edge of the second semiconductor region of each of the plurality of photodetection units when viewed in the direction orthogonal to the first surface, and
the skirt portion of the light-condensing structure in each of the plurality of first openings overlaps the outer edge of the second semiconductor region of each of the plurality of photodetection units and the entirety of each of the plurality of quenching resistors when viewed in the direction orthogonal to the first surface.

19. The photodetector according to any one of claims 15 to 18,
wherein the semiconductor layer has a trench extending to partition the plurality of photodetection units from each other, and
a top portion of the light-condensing structure on a side opposite to the semiconductor photodetection element, and the trench are included in the readout wiring when viewed in the direction orthogonal to the first surface.

20. The photodetector according to any one of claims 11 to 14,
wherein the semiconductor layer has a trench extending to partition the plurality of photodetection units from each other, and
the trench is included in the light-condensing structure when viewed in the direction orthogonal to the first surface.

21. The photodetector according to claim 20,
wherein the semiconductor photodetection element further includes a wiring layer formed on the first surface,
the wiring layer includes a plurality of annular electrodes arranged to correspond to the plurality of photodetection units,
in each of the plurality of photodetection units, a region between the second semiconductor region and the trench is included in each of the plurality of annular electrodes when viewed in the direction orthogonal to the first surface, and
an inner edge of each of the plurality of annular electrodes has a polygonal shape having a plurality of chamfered corners.
